# EUROPEAN PATENT APPLICATION

(11) **EP 2 587 903 A2**
(43) Date of publication of application: **01.05.2013**
(21) Application number: 12165416.4
(22) Date of filing: 24.04.2012
(51) Int. Cl.: H05K 5/02

(54) **Housing and electronic device using same**

(30) Priority: 24.10.2011 CN 201110325625
(71) Applicant: Shenzhen Futaihong Precision Industry Co., Ltd., Shenzhen City, Guangdong Province 518109 (CN); FIH (Hong Kong) Limited, Cheung Sha Wan Kowloon, Hong Kong (CN)
(72) Inventor: Zou, Zhi-Qing, 518109 Shenzhen City, Guangdong (CN); Lin, He-Xian, 518109 Shenzhen City, Guangdong (CN)
(74) Representative: Gray, John James

(57) **Abstract**

A housing for an electronic device comprises a main body and a number of prismatic-shaped protrusions formed on a surface of the main body. Each protrusion has a top surface slanted relative to the main body. Observing from the side of the housing, the top surfaces present different visual effects of light and shade due to setting the top surfaces at different angles, which makes the protrusions present a desired pattern.

## Description

### Field

The disclosure relates to a housing and an electronic device employing the housing.

### BackGround

Many housings of portable electronic devices are surface treated to form patterns to present attractive appearances. The surface treatment method may be a laser engraving process, an anodic oxidation process, or a chemical etching process. However, these methods are not always so successful at forming novel and attractive patterns.

Therefore, there is room for improvement within the art.

### Summary

According to one aspect of the disclosure, a housing for an electronic device is provided. The housing includes a main body and a plurality of prismatic-shaped protrusions formed on a surface of the main body. Each protrusion has a top surface slanted relative to the main body.

According to another aspect of the disclosure, an electronic device using a housing is provided. The housing includes a main body and a plurality of prismatic-shaped protrusions formed on a surface of the main body. Each protrusion has a top surface slanted relative to the main body.

### BRIEF DESCRIPTION OF THE DRAWINGS

Many aspects of the housing and the portable electronic device can be better understood with reference to the following drawings. The components in the drawings are not necessarily drawn to scale, the emphasis instead being placed upon clearly illustrating the principles of the housing and the portable electronic device. Moreover, in the drawings like reference numerals designate corresponding parts throughout the several views. Wherever possible, the same reference numbers are used throughout the drawings to refer to the same or like elements of an embodiment.

FIG. 1 is a schematic view of a first exemplary embodiment of a housing.

FIG. 2 is a partial enlarged view of FIG. 1.

FIG. 3 is a schematic view of a second exemplary embodiment of a housing.

### DETAILED DESCRIPTION

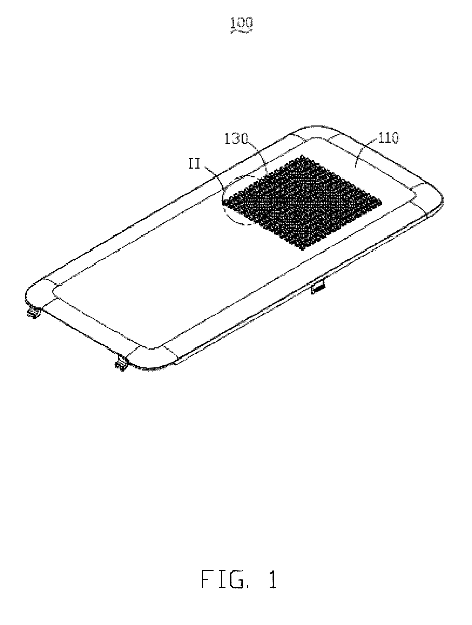

FIG. 1 shows a housing 100 according to a first exemplary embodiment. The housing 100 is made of plastic, glass, or ceramic. The housing 100 includes a plate-shaped main body 110 and a plurality of equally spaced apart prismatic-shaped protrusions 130 defined on a surface of the main body 110.

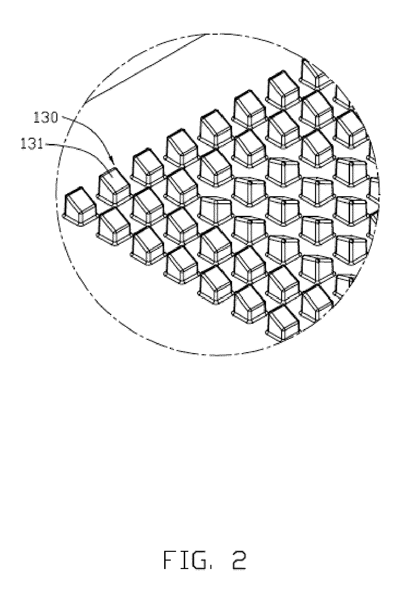

FIG. 2 shows an enlarged view of the housing 100. Each protrusion 130 has a top surface 131. Each top surface 131 is a quadrilateral surface slanted relative to the main body 110. The directions and angles of the slanting relative to the main body can be set as needed to create different visual effects. Observing from the side of the housing 100, the top surfaces 131 present different visual effects of light and shade due to setting the top surfaces 131 at different angles, which makes the protrusions 130 present a desired pattern.

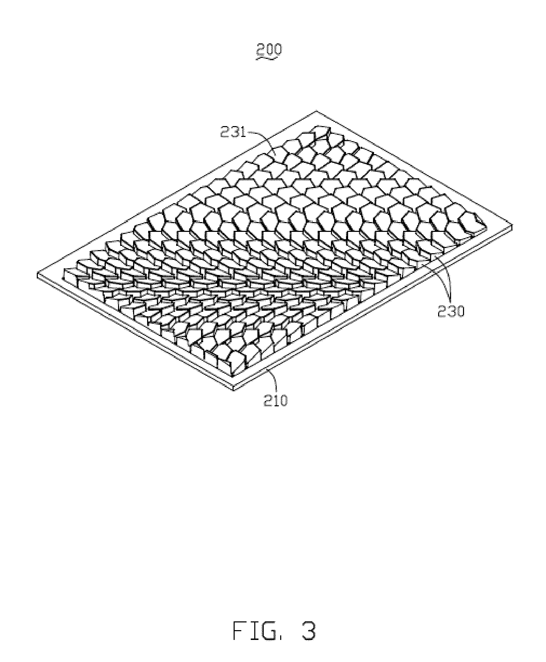

FIG. 3 shows a housing 200 according to a second exemplary embodiment. The housing 200 includes a plate-shaped main body 210 and a plurality of prismatic-shaped protrusions 230 formed on a surface of the main body 210. Where in the first embodiment adjacent protrusions 130 are spaced apart, in this second embodiment, adjacent protrusions 230 are not spaced apart and are in contact with each other. Each protrusion 230 also has a top surface 231 which is an irregular polygon surface slanted relative to the main body 210. As in the previous embodiment, directions and angles of the slanting can be set as needed to create different visual effects.

The top surfaces 131 and 231 of the protrusions 130 and 230 can also be other shapes, such as elliptical, triangular, or other polygonal shapes.

The top surfaces 131 and 231 of the protrusions 130 and 230 may be coated with a layer of paint or other materials to enhance reflectivity or to protect the housings 100 and 200.

The housings 100 and 200 can be used as shells of electronic devices.

It is believed that the exemplary embodiment and its advantages will be understood from the foregoing description, and it will be apparent that various changes may be made thereto without departing from the spirit and scope of the disclosure or sacrificing all of its advantages, the examples hereinbefore described merely being preferred or exemplary embodiment of the disclosure.

## Claims

1. A housing for an electronic device, comprising:
a main body;
a plurality of prismatic-shaped protrusions formed on a surface of the main body;
each protrusion having a top surface slanted relative to the main body.

2. The housing as claimed in claim 1, wherein the protrusions are equally spaced apart from each other.

3. The housing as claimed in claim 1, wherein every two adjacent protrusions are in contact with each other.

4. The housing as claimed in claim 1, wherein there is a plurality of slanting directions for the top surfaces to the main body.

5. The housing as claimed in claim 1, wherein there is a plurality of slanting angles for the top surfaces to the main body.

6. The housing as claimed in claim 1, wherein the top surface is a polygonal surface.

7. The housing as claimed in claim 1, wherein the main body is plate-shaped.

8. The housing as claimed in claim 1, wherein each top surface is coated with a reflection layer or a protective layer.

9. An electronic device using a housing, wherein the housing comprises a main body and a plurality of prismatic-shaped protrusions formed on a surface of the main body, each protrusion has a top surface slanted relative to the main body.

10. The electronic device as claimed in claim 9, wherein the protrusions are equally spaced apart from each other.

11. The housing as claimed in claim 9, wherein every two adjacent protrusions are in contact with each other.

12. The electronic device as claimed in claim 9, wherein the top surface is a polygonal surface.

13. The electronic device as claimed in claim 9, wherein the main body is plate-shaped.

14. The electronic device as claimed in claim 9, wherein each top surface is coated with a reflection layer or a protective layer.

15. The electronic device as claimed in claim 9, wherein there is a plurality of slanting angles and slanting directions for the top surfaces to the main body.
